# EUROPEAN PATENT SPECIFICATION

(11) **EP 1 145 338 B1**
(45) Date of publication and mention of the grant of the patent: **05.12.2012**
(21) Application number: 99966309.9
(22) Date of filing: 15.12.1999
(51) Int. Cl.: H01L 51/50

(54) **ENVIRONMENTAL BARRIER MATERIAL FOR ORGANIC LIGHT EMITTING DEVICE AND METHOD OF MAKING**
UMWELT-SPERRMATERIAL FÜR ORGANISCHE ELEKTROLUMINESZENTE VORRICHTUNG UND HERSTELLUNGSVERFAHREN
MATIERE DE BARRIERE CONTRE LES CONDITIONS D'AMBIANCE DESTINEE A DES DISPOSITIFS ELECTROLUMINESCENTS ORGANIQUES ET SON PROCEDE DE FABRICATION

(30) Priority: 16.12.1998 US 212779; 25.10.1999 US 427138
(43) Date of publication of application: 17.10.2001
(60) Divisional application: 04257900.3
(73) Proprietor: Samsung Display Co., Ltd., Yongin-City, Gyeonggi-Do, 446-711 (KR)
(72) Inventor: GRAFF, Gordon, L., West Richland, WA 99353 (US); GROSS, Mark, E., Pasco, WA 99301 (US); AFFINITO, John, D., Tueson Arizona 85718 (US); SHI, Ming-Kun, Arcadia, CA 91007 (US); HALL, Michael, G., West Richland, WA 99353 (US); MAST, Eric, S., Richland, WA 99352 (US)
(74) Representative: Caldwell, Judith Margaret
(86) International application number: PCT/US1999/029853
(87) International publication number: WO 2000/036665

(56) References cited:
- EP-A- 0 977 469
- DE-A- 19 603 746
- US-A- 5 547 508
- US-A- 5 757 126
- AFFINITO J D ET AL: "PML/oxide/PML barrier layer performance differences arising from use of UV or electron beam polymerization of the PML layers" THIN SOLID FILMS,CH,ELSEVIER-SEQUOIA S.A. LAUSANNE, vol. 308-309, no. 1-4, 31 October 1997 (1997-10-31), pages 19-25, XP004110238 ISSN: 0040-6090 cited in the application

## Description

### BACKGROUND OF THE INVENTION

The present invention relates to organic light emitting devices (OLEDs), and more particularly to OLEDs encapsulated in barrier stacks.

There is a need for versatile visual displays for electronic products of many different types. Light emitting diodes (LEDs) and liquid crystal displays (LCDs) have found many useful applications, but they are not adequate for all situations. OLEDs are a relatively new type of visual display which has shown great promise. An OLED basically includes an organic electroluminescent substance placed between two electrodes. When an electric potential is applied across the electrodes, the electroluminescent substance emits visible light. Typically, one of the electrodes is transparent, allowing the light to shine through. U.S. Patent Nos. 5,629,389 (Roitman et al.), 5,747,182 (Friend et al.), 5,844,363 (Gu et al.), 5,872,355 (Hueschen), 5,902,688 (Antoniadis et al.), and 5,948,552 (Antoniadis et al.), disclose various OLED structures.

The use of OLEDs in flat panel displays and other information display formats is limited by the poor environmental stability of the devices. G.Gustafson, Y.Cao, G.M.Treacy, F.Klavetter, N.Colaneri, and A.J.Heeger, Nature, Vol. 35, 11 June 1992, pages 477-479. Humidity and oxygen significantly reduce the useful life of most OLEDs. As a result, these devices are typically fabricated on glass substrates with glass covers laminated on top of the OLED and with the edges sealed to exclude water and oxygen from the active layers. U.S. Patent No. 5,872,355 discloses the use of a polymer such as saran to seal the device. The water vapor permeation rates (WVTR) required to provide sufficient lifetime for OLEDs is calculated to be approximately 10⁻⁶ g/m²/day. The best polymer films (such as saran) have WVTR values that are 5 orders of magnitude too high to be considered for OLED encapsulation. Furthermore, saran cannot be deposited using flash evaporation, condensation, and in situ polymerization within a vacuum chamber.

Thus, there is a need for an improved lightweight, barrier construction which can be used to encapsulate the OLED and prevent the deterioration caused by permeation of oxygen and water vapor and for a method of making such an encapsulated OLED.

### SUMMARY OF THE INVENTION

These needs are met by the present invention, which is an encapsulated organic light emitting device (OLED) comprising: a substrate; an organic light emitting layer stack on the substrate; and at least two first barrier stacks for providing protection from oxygen and water permeation over the organic light emitting layer stack and encapsulating the organic light emitting layer stack, each of the at least two first barrier stacks comprising one or more barrier layers and one or more polymer layers on one or both sides of the barrier layers; wherein the barrier layers are transparent and comprise a material selected from metal and silicon oxides, metal and silicon nitrides, metal and silicon carbides, metal and silicon oxynitrides, and combinations thereof; and wherein a polymer layer of one first barrier stack is in contact with a barrier layer of the other first barrier stack; and wherein the encapsulated organic light emitting device is obtainable by the method of: vacuum depositing the barrier stacks, the vacuum depositing comprising: flash evaporating and condensing acrylate-containing monomers, oligomers, or resins; and polymerising the condensed evaporated acrylate-containing monomers, oligomers, or resins in situ under vacuum to form the polymer layers; and vacuum depositing the barrier layers. The device may further comprise at least one second barrier stack between the substrate and the organic light emitting layer stack. The second barrier stack has at least one second barrier layer and at least one second polymer layer on one or both sides of the barrier layers.

Preferably, either one or both of the barrier layers of the first and second barrier stacks is transparent. The metal oxides are preferably selected from silica, alumina, titania, indium oxide, tin oxide, indium tin oxide, and combinations thereof, the metal nitrides are preferably selected from aluminum nitride, silicon nitride, and combinations thereof, the metal carbide is preferably silicon carbide, and the metal oxynitride is preferably silicon oxynitride.

The substrate can be either a flexible substrate or a rigid substrate. It is preferably a flexible substrate material, which can be polymers, metals, paper, fabric, and combinations thereof. The rigid substrate is preferably glass, metal, or silicon. If a rigid substrate is used, it can be removed prior to use if desired.

The polymer layers of the first and second barrier stacks are acrylate-containing polymers (as used herein, the term acrylate-containing polymer includes acrylate-containing polymers, methacrylate-containing polymers, and combinations thereof). The polymer layers in the first and/or the second barrier stacks can be the same or different.

The organic light emitting layer stack preferably comprises a first electrode, an electroluminescent layer, and a second electrode. The electroluminescent layer preferably includes a hole transporting layer, and an electron transporting layer, as is known in the art and shown in the patents referred to herein.

The invention also involves a method of making the encapsulated organic light emitting device. The method comprises providing a substrate; providing an organic light emitting layer stack on the substrate; and vacuum depositing at least two first barrier stacks for providing protection from oxygen and water permeation over the organic light emitting layer stack to encapsulate the organic light emitting layer stack, each of the at least two first barrier stacks comprising one or more barrier layers and one or more polymer layers on one or both sides of the barrier layers; wherein the barrier layers are transparent and comprise a material selected from metal and silicon oxides, metal and silicon nitrides, metal and silicon carbides, metal and silicon oxynitrides, and combinations thereof; and wherein a polymer layer of one first barrier stack is in contact with a barrier layer of the other first barrier stack; and wherein the vacuum depositing comprises: flash evaporating and condensing acrylate-containing monomers, oligomers, or resins; and polymerising the condensed evaporated acrylate-containing monomers, oligomers, or resins in situ under vacuum to form the polymer layers; and vacuum depositing the barrier layers.

An alternative method of making an encapsulated organic light emitting device in accordance with the invention comprises: providing a substrate; providing an organic light emitting layer stack on the substrate; and vacuum depositing at least two first barrier stacks for providing protection from oxygen and water permeation, each of the at least two first barrier stacks comprising one or more barrier layers and one or more polymer layers on one or both sides of the barrier layers; wherein the barrier layers are transparent and comprise a material selected from metal and silicon oxides, metal and silicon nitrides, metal and silicon carbides, metal and silicon oxynitrides, and combinations thereof; and wherein a polymer layer of one first barrier stack is in contact with a barrier layer of the other first barrier stack; the vacuum depositing comprising: flash evaporating and condensing acrylate-containing monomers, oligomers, or resins; and polymerising the condensed evaporated acrylate-containing monomers, oligomers, or resins in situ under vacuum to form the polymer layers; and vacuum depositing the barrier layers; and laminating the at least two first barrier stacks over the organic light emitting layer stack to encapsulate the organic light emitting layer stack.

The method can also include forming at least one second barrier stack between the substrate and the organic light emitting layer stack before the organic light emitting layer stack is formed. The second barrier stack comprises at least one barrier layer and at least one polymer layer on one or both sides of the barrier layers.

The organic light emitting layer stack can be combined with the first barrier stack and/or the second barrier stack by laminating them together. Alternatively, they can be combined simultaneously with forming by depositing one layer on the other.

The barrier stack is preferably laminated (edge sealed) using an adhesive, but other methods can be used including heat.

Accordingly, it is an object of the present invention to provide an encapsulated OLED, and to provide a method of making such a device.

### BRIEF DESCRIPTION OF THE DRAWINGS

Fig. 1 is a cross-section of an encapsulated OLED that does not form part of the present invention.
Fig. 2 is a cross-section of an embodiment of the encapsulated OLED of the present invention.
Fig. 3 is a cross-section of another embodiment of an encapsulated OLED of the present invention.

### DESCRIPTION OF THE INVENTION

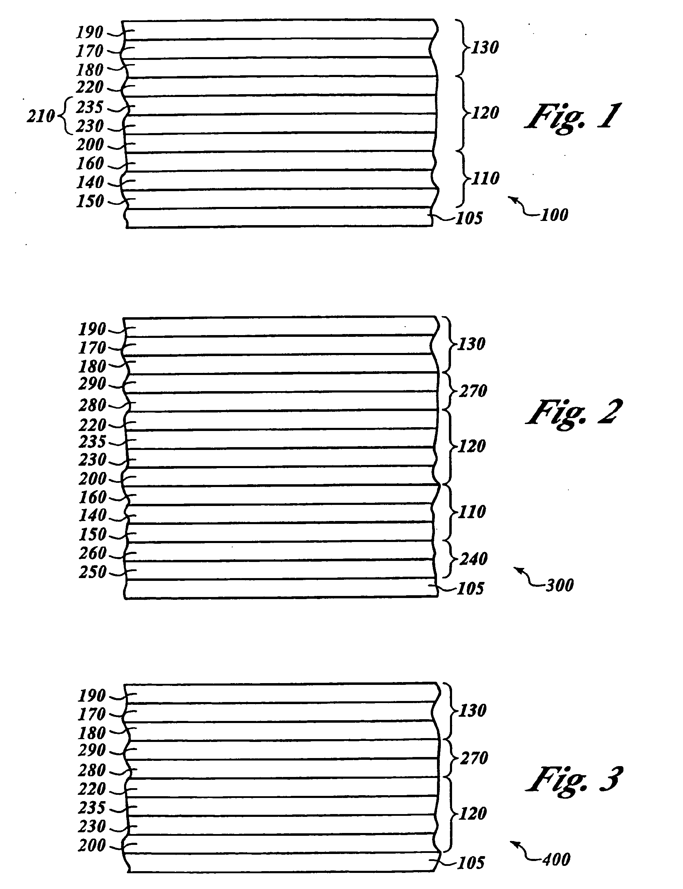

An encapsulated OLED 100 which does not fall within the scope of the claimed invention is shown in Fig. 1. The encapsulated OLED 100 includes substrate 105, a first barrier stack 110, an organic light emitting layer stack 120, and a second barrier stack 130. The first barrier stack 110 has a first barrier layer 140 and two polymer layers 150, 160. The second encapsulation layer 130 includes a second barrier layer 170 and two polymer layers 180, 190.

Although the Figures show barrier stacks with a single polymer layer on both sides of a single barrier layer, the barrier stacks can have one or more polymer layers and one or more barrier layers. There could be one polymer layer and one barrier layer, there could be multiple polymer layers on one side of one or more barrier layers, or there could be one or more polymer layers on both sides of one or more barrier layers. The important feature is that the barrier stack have at least one polymer layer and at least one barrier layer.

The organic light emitting layer stack 120 includes a first electrode layer 200, an electroluminescent layer 210, and a second electrode 220. The electroluminscent layer 210 can include a hole transport layer 230, and an electron transport layer 235. The exact form and composition of the organic light emitting layer stack is not critical. The organic light emitting layer stack includes first and second electrode layers on opposite sides of one or more active layers. The electrode layers are connected to a power source. At least one of the electrodes is transparent. The electroluminescent layer may be multiple layers as shown, or a single layer. The electroluminescent layer typically includes a hole injection layer, a hole transport layer, an electron transport layer, and an emissive layer, and combinations thereof. Additional layers may also be present, including dielectric layers. The organic light emitting layer stack can be made using known techniques, such as those described in U.S. Patent Nos. 5,629,389 (Roitman et al.), 5,844,363 (Gu et al.), 5,872,355 (Hueschen), 5,902,688 (Antoniadis et al.), and 5,948,552 (Antoniadis et al.).

The present invention is compatible with organic light emitting layer stacks made with light emitting polymers and small molecules.

In the embodiment of the invention shown in Fig. 2, the encapsulated OLED 300 also includes an additional first barrier stack 240 and an additional second barrier stack 270. The additional first barrier stack is located between the substrate 105 and the first barrier stack 110, and it includes a polymer layer 250 and a barrier layer 260. The additional second barrier stack 270 includes a polymer layer 280 and a barrier layer 290. The additional second barrier stack 270 is located between the organic light emitting layer stack 120 and the second barrier stack 130. Alternatively, the additional second layer could be located between the first barrier layer and the organic light emitting layer stack. In addition, there could be multiple additional first barrier stacks on top of one another to provide enhanced barrier protection. Similarly, there could be multiple additional second barrier stacks on top of one another. The order of the barrier and polymer layers in the additional first and second barrier stacks is not critical. It depends on where the additional barrier stack is located and what layers are next to them.

The encapsulated OLED can be made by forming the first barrier stack 110, the organic light emitting layer stack 120, and the second barrier stack 130. The stacks are combined to form the encapsulated OLED.

The stacks are combined by forming them using vacuum deposition. In this method, one layer is vacuum deposited on the previous layer, thereby combining the layers simultaneously with forming them. Alternatively, the organic light emitting layer stack can be combined with the first and second barrier stacks by laminating it between the first and second barrier stacks and sealing it along the edges with adhesive, glue, or the like, or by heating. The first and second barrier stacks include at least one barrier layer and at least one polymer layer. If a polymer/barrier/polymer structure is desired, it can be preferably formed as follows. These barrier stacks can be formed by depositing a layer of an acrylate-containing polymer, onto a substrate or previous layer. An acrylate-containing monomer, oligomer or resin (as used herein, the term acrylate-containing monomer, oligomer, or resin includes acrylate-containing monomers, oligomers, and resins, methacrylate-containing monomers, oligomers, and resins, and combinations thereof) is deposited and then polymerized *in situ* to form the polymer layer. The acrylate-containing polymer layer is then coated with a barrier layer. Another polymer layer is deposited onto the barrier layer. U.S. Patent Nos. 5,440,446 and 5,725,909, describe methods of depositing thin film, barrier stacks.

The barrier stacks are vacuum deposited. Vacuum deposition includes flash evaporation of acrylate-containing monomer, oligomer, or resin with *in situ* polymerization under vacuum, as well as vacuum deposition of the barrier layers, e.g. by sputtering, chemical vapor deposition, plasma enhanced chemical vapor deposition, evaporation, sublimation, electron cyclotron resonance-plasma enhanced vapor deposition (ECR-PECVD), and combinations thereof.

It is critical to protect the integrity of the barrier layer to avoid the formation of defects and/or microcracks in the deposited layer. The encapsulated OLED is preferably manufactured so that the barrier layers are not directly contacted by any equipment, such as rollers in a web coating system, to avoid defects that may be caused by abrasion over a roll or roller. This can be accomplished by designing the deposition system such that a set of layers of polymer/barrier/polymer are deposited prior to contacting or touching any handling equipment.

The substrate can be flexible or rigid. The flexible substrate may be any flexible material, including, but not limited to, polymers, for example polyethlyene terephthalate (PET), polyethylene naphthalate (PEN), or high temperature polymers such as polyether sulfone (PES), polyimides, or Transphan™ (a high Tg cyclic olefin polymer available from Lofo High Tech Film, GMBH of Weil am Rhein, Germany), metal, paper, fabric, and combinations thereof. The rigid substrate is preferably glass, metal, or silicon. If a flexible, encapsulated OLED is desired and a rigid substrate was used during manufacture, the rigid substrate is preferably removed prior to use.

The polymer layers of the first and second barrier stacks and the polymer layers of the additional first and second barrier stacks are acrylate-containing monomer, oligomer or resin, and combinations thereof. The polymer layers of the first and second barrier stacks and additional first and second barrier stacks can be the same or they can be different. In addition, the polymer layers within the each barrier stack can be the same or different.

The barrier layers in the barrier stacks may be any barrier material. The barrier materials in the first and second barrier stacks and the additional first and second barrier stacks can be the same or different. In addition, multiple layers of the same or different barrier layers can be used in a stack. Preferred transparent barrier materials include, but are not limited to, metal oxides, metal nitrides, metal carbides, metal oxynitrides, and combinations thereof. The metal oxides are preferably selected from silica, alumina, titania, indium oxide, tin oxide, indium tin oxide, and combinations thereof, the metal nitrides are preferably selected from aluminum nitride, silicon nitride, and combinations thereof, the metal carbide is preferably silicon carbide, and the metal oxynitride is preferably silicon oxynitride. Since only one side of the device must be transparent, only one of the barrier layers must be transparent. In this situation, the barrier layer on the opposite side could be an opaque barrier material, including, but not limited to, metal, ceramic or polymer.

An alternate encapsulated OLED is shown in Fig. 3. The encapsulated OLED 400 has a substrate 105 on which is fabricated an organic light emitting layer stack 120. A barrier stack 130 is deposited conformally over the organic light emitting layer stack 120, encapsulating it. The polymer layers in the barrier stack are deposited in vacuum. A preferred method of forming the barrier stack is flash evaporating acrylate-containing monomers, oligomers or resins, condensing on the OLED layer stack, and polymerizing in-situ in a vacuum chamber. The barrier layer is then deposited on the polymer layer using conventional vacuum processes such as evaporation, sputtering, CVD, PECVD or ECR-PECVD. A second polymer layer is then deposited on the barrier layer using the process described above.

Alternatively, the OLED device could also be encapsulated by laminating a lid structure, containing the barrier stack, to the substrate over the organic light emitting layer structure. The lamination can be performed using either adhesive, or glue, or the like, or by heating. The encapsulated OLED could also include an additional barrier stack 270 as shown. If the substrate is transparent, then the barrier material could be opaque, or vice versa, as discussed above.

A single pass, roll-to-roll, vacuum deposition of a three layer combination on a PET substrate, i.e., PET substrate/polymer layer/barrier layer/polymer layer, can be more than five orders of magnitude less permeable to oxygen and water vapor than a single oxide layer on PET alone. See J.D.Affinito, M.E.Gross, C.A.Coronado, G.L.Graff, E.N.Greenwell, and P.M.Martin, Polymer-Oxide Transparent Barrier Layers Produced Using PML Process, 39th Annual Technical Conference Proceedings of the Society of Vacuum Coaters, Vacuum Web Coating Session, 1996, pages 392-397; J.D.Affinito, S.Eufinger, M.E.Gross, G.L.Graff, and P.M.Martin, PML/Oxide/PML Barrier Layer Performance Differences Arising From Use of UV or Electron Beam Polymerization of the PML Layers, Thin Solid Films, Vol.308, 1997, pages 19-25. This is in spite of the fact that the effect on the permeation rate of the polymer multilayers (PML) layers alone, without the barrier layer (oxide, metal, nitride, oxynitride) layer, is barely measurable. It is believed that the improvement in barrier properties is due to two factors. First, permeation rates in the roll-to-roll coated oxide-only layers were found to be conductance limited by defects in the oxide layer that arose during deposition and when the coated substrate was wound up over system idlers/rollers. Asperities (high points) in the underlying substrate are replicated in the deposited inorganic barrier layer. These features are subject to mechanical damage during web handling/take-up, and can lead to the formation of defects in the deposited film. These defects seriously limit the ultimate barrier performance of the films. In the single pass, polymer/barrier/polymer process, the first acrylic layer planarizes the substrate and provides an ideal surface for subsequent deposition of the inorganic barrier thin film. The second polymer layer provides a robust "protective" film that minimizes damage to the barrier layer and also planarizes the structure for subsequent barrier layer (or organic light emitting layer stack) deposition. The polymer layers of the additional barrier stacks also decouple defects that exist in adjacent inorganic barrier layers, thus creating a tortuous path for gas diffusion. The permeability of the barrier stacks used in the present invention is shown below.

**Table 1**

| **Sample** | **Oxygen Permeation Rate (cc/m²/day)** | | **Water vapor Permeation (g/m²/day)⁺** |
|---|---|---|---|
| | **23°C*** | **38°C⁺** | **38°C⁺** |
| 1-barrier stack | <0.005 | <0.005 | 0.46 |
| 2- barier stacks | <0.005 | <0.005 | <0.005 |
| 5-barrier stacks | <0.005 | <0.005 | <0.005 |

| | | | |
|---|---|---|---|
| * 38°C, 90% RH, 100% O₂ + 38°C, 100% RH NOTE: Permeation rates of <0.005 are below the detection limits of current instrumentation (Mocon OxTran 2/20L). | | | |

As can be seen from the data in Table 1, the barrier stacks used in the present invention provide exceptional environmental protection, which was previously unavailable with polymers.

We have also compared the performance of OLED devices (fabricated on glass and silicon) before and after encapsulation using the barrier stacks of the present invention. After encapsulation, the current density-versus-voltage and brightness-versus-current density characteristics were identical (within experimental error) to the measured behavior of the pristine (unencapsulated) devices. This shows that the barrier stacks and deposition methods are compatible with OLED device manufacturing.

Thus, the present invention provides a barrier stack with the exceptional barrier properties necessary for hermetic sealing of an OLED. It permits the production of an encapsulated OLED.

While certain representative embodiments and details have been shown for purposes of illustrating the invention, various changes in the compositions and methods disclosed herein may be made, the invention being defined in the appended claims.

## Claims

1. An encapsulated organic light emitting device comprising:
a substrate;
an organic light emitting layer stack on the substrate; and
at least two first barrier stacks for providing protection from oxygen and water permeation over the organic light emitting layer stack and encapsulating the organic light emitting layer stack, each of the at least two first barrier stacks comprising one or more barrier layers and one or more polymer layers on one or both sides of the barrier layers;
wherein the barrier layers are transparent and comprise a material selected from metal and silicon oxides, metal nitrides and silicon nitrides, metal carbides and silicon carbides, metal oxynitrides and silicon oxynitrides, and combinations thereof; and
wherein a polymer layer of one first barrier stack is in contact with a barrier layer of the other first barrier stack; and
wherein the encapsulated organic light emitting device is obtainable by the method of:
vacuum depositing the barrier stacks,
the vacuum depositing comprising:
flash evaporating and condensing acrylate-containing monomers, oligomers, or resins; and polymerising the condensed evaporated acrylate-containing monomers, oligomers, or resins *in situ* under vacuum to form the polymer layers; and
vacuum depositing the barrier layers.

2. The encapsulated organic light emitting device of Claim 1, further comprising at least one second barrier stack for providing protection from oxygen and water permeation located between the substrate and the organic light emitting layer stack, the at least one second barrier stack comprising one or more barrier layers and one or more polymer layers on one or both sides of the barrier layers,
wherein the second barrier stack is obtainable by the method of:
vacuum depositing the barrier stack, the vacuum depositing comprising:
flash evaporating and condensing acrylate-containing monomers, oligomers, or resins; and polymerising the condensed evaporated acrylate-containing monomers, oligomers, or resins to form the second polymer layer; and
vacuum depositing the second barrier layer.

3. The encapsulated organic light emitting device of Claim 1, wherein the first barrier stacks are transparent.

4. The encapsulated organic light emitting device of Claim 2, wherein the one or more barrier layers of the second barrier stacks is substantially transparent.

5. The encapsulated organic light emitting device of any preceding claim, wherein the metal and silicon oxides are selected from silica, alumina, titania, indium oxide, tin oxide, indium tin oxide, and combinations thereof.

6. The encapsulated organic light emitting device of any preceding claim, wherein the barrier material is selected from aluminum nitride, silicon nitride, and combinations thereof.

7. The encapsulated organic light emitting device of any preceding claim, wherein the barrier material is silicon carbide.

8. The encapsulated organic light emitting device of any preceding claim, wherein the barrier material is silicon oxynitride.

9. The encapsulated organic light emitting device of any of Claims 4 to 8, wherein at least one barrier layer of the second barrier stack is opaque.

10. The encapsulated organic light emitting device of Claim 9, wherein the at least one opaque barrier layer is selected from opaque metals, opaque polymers, and opaque ceramics.

11. The encapsulated organic light emitting device of any of the preceding claims, wherein the substrate comprises a rigid substrate material.

12. The encapsulated organic light emitting device of Claim 11, wherein the rigid substrate material is selected from glass, metal, and silicon.

13. The encapsulated organic light emitting device of any of Claims 1 to 10, wherein the substrate comprises a flexible substrate material.

14. The encapsulated organic light emitting device of Claim 13, wherein the flexible substrate material is selected from polymers, metals, paper, fabric, and combinations thereof.

15. A method of making an encapsulated organic light emitting device comprising:
providing a substrate;
providing an organic light emitting layer stack on the substrate; and
vacuum depositing at least two first barrier stacks for providing protection from oxygen and water permeation over the organic light emitting layer stack to encapsulate the organic light emitting layer stack, each of the at least two first barrier stacks comprising one or more barrier layers and one or more polymer layers on one or both sides of the barrier layers; wherein the barrier layers are transparent and comprise a material selected from metal oxides and silicon oxides, metal nitrides and silicon nitrides, metal carbides and silicon carbides, metal oxynitrides and silicon oxynitrides, and combinations thereof; and
wherein a polymer layer of one first barrier stack is in contact with a barrier layer of the other first barrier stack; and
wherein the vacuum depositing comprises:
flash evaporating and condensing acrylate-containing monomers, oligomers, or resins; and polymerising the condensed evaporated acrylate-containing monomers, oligomers, or resins *in situ* under vacuum to form the polymer layers; and
vacuum depositing the barrier layers.

16. A method of making an encapsulated organic light emitting device comprising:
providing a substrate;
providing an organic light emitting layer stack on the substrate; and
vacuum depositing at least two first barrier stacks for providing protection from oxygen and water permeation, each of the at least two first barrier stacks comprising one or more barrier layers and one or more polymer layers on one or both sides of the barrier layers;
wherein the barrier layers are transparent and comprise a material selected from metal oxides and silicon oxides, metal nitrides and silicon nitrides, metal carbides and silicon carbides, metal oxynitrides and silicon oxynitrides, and combinations thereof; and
wherein a polymer layer of one first barrier stack is in contact with a barrier layer of the other first barrier stack;
the vacuum depositing comprising:
flash evaporating and condensing acrylate-containing monomers, oligomers, or resins; and polymerising the condensed evaporated acrylate-containing monomers, oligomers, or resins *in situ* under vacuum to form the polymer layers; and
vacuum depositing the barrier layers; and
laminating the at least two first barrier stacks over the organic light emitting layer stack to encapsulate the organic light emitting layer stack.

17. The method of Claim 15 or Claim 16, further comprising vacuum depositing at least one second barrier stack between the substrate and the organic light emitting layer stack for providing protection from oxygen and water permeation, the at least one second barrier stack comprising one or more barrier layers and one or more polymer layers on one or both sides of the barrier layers, the vacuum depositing comprising:
flash evaporating and condensing acrylate-containing monomers, oligomers, or resins; and polymerising the condensed acrylate-containing monomers, oligomers, or resins to form the polymer layer; and
vacuum depositing the second barrier layer.

18. The method of Claim 15 or Claim 16, wherein in the first barrier stacks one or more polymer layers is deposited before the one or more barrier layers.

19. The method of Claim 17, wherein in the second barrier stack one or more polymer layers is deposited before the one or more barrier layers.

20. The method of Claim 16, wherein the lamination is performed using an adhesive.

21. The method of Claim 16, wherein the lamination is performed using heat.

22. The method of any of Claims 15 to 21, wherein the first barrier stacks are transparent.

23. The method of Claim 17, wherein the one or more barrier layers of the second barrier stacks is substantially transparent.

24. The method of Claim 23, wherein at least one barrier layer of the second barrier stack is opaque.

## Patentansprüche

1. Gekapselte organische lichtemittierende Vorrichtung, die Folgendes umfasst:
ein Substrat;
einen organischen lichtemittierenden Schichtenstapel auf dem Substrat; und
mindestens zwei erste Sperrstapel zum Vorsehen von Schutz vor Sauerstoff- und Wasserpermeation über dem organischen lichtemittierenden Schichtenstapel und Kapseln des organischen lichtemittierenden Schichtenstapels, wobei die mindestens zwei ersten Sperrstapel jeweils eine oder mehrere Sperrschichten und eine oder mehrere Polymerschichten auf einer oder beiden Seiten der Sperrschichten umfassen;
wobei die Sperrschichten transparent sind und ein Material umfassen, das ausgewählt ist aus Metalloxiden und Siliziumoxiden, Metallnitriden und Siliziumnitriden, Metallkarbiden und Siliziumkarbiden, Metalloxynitriden und Siliziumoxynitriden und Kombinationen davon; und
wobei eine Polymerschicht eines ersten Sperrstapels mit einer Sperrschicht des anderen ersten Sperrstapels in Kontakt steht; und
wobei die gekapselte organische lichtemittierende Vorrichtung durch Folgendes Verfahren erhalten werden kann:
Vakuumabscheiden der Sperrstapel,
wobei das Vakuumabscheiden Folgendes umfasst:
Entspannungsverdampfen und Kondensieren von acrylathaltigen Monomeren, Oligomeren oder Harzen; und Polymerisieren der kondensierten verdampften acrylathaltigen Monomere, Oligomere oder Harze *in situ* unter Unterdruck, um die Polymerschichten zu bilden; und
Vakuumabscheiden der Sperrschichten.

2. Gekapselte organische lichtemittierende Vorrichtung nach Anspruch 1, weiter umfassend mindestens einen zweiten Sperrstapel zum Vorsehen von Schutz vor Sauerstoff- und Wasserpermeation, der sich zwischen dem Substrat und dem organischen lichtemittierenden Schichtenstapel befindet, wobei der mindestens eine zweite Sperrstapel eine oder mehrere Sperrschichten und eine oder mehrere Polymerschichten auf einer oder beiden Seiten der Sperrschichten umfasst,
wobei der zweite Sperrstapel durch folgendes Verfahren erhalten werden kann:
Vakuumabscheiden des Sperrstapels, wobei das Vakuumabscheiden Folgendes umfasst: Entspannungsverdampfen und Kondensieren von acrylathaltigen Monomeren, Oligomeren oder Harzen; und Polymerisieren der kondensierten verdampften acrylathaltigen Monomere, Oligomere oder Harze, um die zweite Polymerschicht zu bilden; und
Vakuumabscheiden der zweiten Sperrschicht.

3. Gekapselte organische lichtemittierende Vorrichtung nach Anspruch 1, wobei die ersten Sperrstapel transparent sind.

4. Gekapselte organische lichtemittierende Vorrichtung nach Anspruch 2, wobei die eine oder mehreren Sperrschichten der zweiten Sperrstapel im Wesentlichen transparent sind.

5. Gekapselte organische lichtemittierende Vorrichtung nach einem der vorangehenden Ansprüche, wobei die Metall- und Siliziumoxide ausgewählt sind aus Siliziumoxid, Aluminiumoxid, Titandioxid, Indiumoxid, Zinnoxid, Indiumzinnoxid, und Kombinationen davon.

6. Gekapselte organische lichtemittierende Vorrichtung nach einem der vorangehenden Ansprüche, wobei das Sperrmaterial ausgewählt ist aus Aluminiumnitrid, Siliziumnitrid, und Kombinationen davon.

7. Gekapselte organische lichtemittierende Vorrichtung nach einem der vorangehenden Ansprüche, wobei es sich bei dem Sperrmaterial um Siliziumkarbid handelt.

8. Gekapselte organische lichtemittierende Vorrichtung nach einem der vorangehenden Ansprüche, wobei es sich bei dem Sperrmaterial um Siliziumoxynitrid handelt.

9. Gekapselte organische lichtemittierende Vorrichtung nach einem der Ansprüche 4 bis 8, wobei mindestens eine Sperrschicht des zweiten Sperrstapels opak ist.

10. Gekapselte organische lichtemittierende Vorrichtung nach Anspruch 9, wobei die mindestens eine opake Sperrschicht ausgewählt ist aus opaken Metallen, opaken Polymeren und opaker Keramik.

11. Gekapselte organische lichtemittierende Vorrichtung nach einem der vorangehenden Ansprüche, wobei das Substrat ein starres Substratmaterial umfasst.

12. Gekapselte organische lichtemittierende Vorrichtung nach Anspruch 11, wobei das starre Substratmaterial ausgewählt ist aus Glas, Metall und Silizium.

13. Gekapselte organische lichtemittierende Vorrichtung nach einem der Ansprüche 1 bis 10, wobei das Substrat ein biegsames Substratmaterial umfasst.

14. Gekapselte organische lichtemittierende Vorrichtung nach Anspruch 13, wobei das biegsame Substratmaterial ausgewählt ist aus Polymeren, Metallen, Papier, Stoff, und Kombinationen davon.

15. Verfahren zum Herstellen einer gekapselten organischen lichtemittierenden Vorrichtung, das Folgendes umfasst:
Bereitstellen eines Substrats;
Bereitstellen eines organischen lichtemittierenden Schichtenstapels auf dem Substrat; und
Vakuumabscheiden von mindestens zwei ersten Sperrstapeln zum Vorsehen von Schutz vor Sauerstoff- und Wasserpermeation über dem organischen lichtemittierenden Schichtenstapel, um den organischen lichtemittierenden Schichtenstapel zu kapseln, wobei die mindestens zwei ersten Sperrstapel jeweils eine oder mehrere Sperrschichten und eine oder mehrere Polymerschichten auf einer oder beiden Seiten der Sperrschichten umfassen; wobei die Sperrschichten transparent sind und ein Material umfassen, das ausgewählt ist aus Metalloxiden und Siliziumoxiden, Metallnitriden und Siliziumnitriden, Metallkarbiden und Siliziumkarbiden, Metalloxynitriden und Siliziumoxynitriden, und Kombinationen davon; und wobei eine Polymerschicht eines ersten Sperrstapels mit einer Sperrschicht des anderen ersten Sperrstapels in Kontakt steht; und
wobei das Vakuumabscheiden Folgendes umfasst:
Entspannungsverdampfen und Kondensieren von acrylathaltigen Monomeren, Oligomeren oder Harzen; und Polymerisieren der kondensierten verdampften acrylathaltigen Monomere, Oligomere oder Harze *in situ* unter Unterdruck, um die Polymerschichten zu bilden; und
Vakuumabscheiden der Sperrschichten.

16. Verfahren zum Herstellen einer gekapselten organischen lichtemittierenden Vorrichtung, das Folgendes umfasst:
Bereitstellen eines Substrats;
Bereitstellen eines organischen lichtemittierenden Schichtenstapels auf dem Substrat; und
Vakuumabscheiden von mindestens zwei ersten Sperrstapeln zum Vorsehen von Schutz vor Sauerstoff- und Wasserpermeation, wobei die mindestens zwei ersten Sperrstapel jeweils eine oder mehrere Sperrschichten und eine oder mehrere Polymerschichten auf einer oder
beiden Seiten der Sperrschichten umfassen;
wobei die Sperrschichten transparent sind und ein Material umfassen, das ausgewählt ist aus Metalloxiden und Siliziumoxiden, Metallnitriden und Siliziumnitriden, Metallkarbiden und Siliziumkarbiden, Metalloxynitriden und Siliziumoxynitriden, und Kombinationen davon; und
wobei eine Polymerschicht eines ersten Sperrstapels mit einer Sperrschicht des anderen ersten Sperrstapels in Kontakt steht;
wobei das Vakuumabscheiden Folgendes umfasst:
Entspannungsverdampfen und Kondensieren von acrylathaltigen Monomeren, Oligomeren oder Harzen; und Polymerisieren der kondensierten verdampften acrylathaltigen Monomere, Oligomere oder Harze *in situ* unter Unterdruck, um die Polymerschichten zu bilden; und
Vakuumabscheiden der Sperrschichten; und
Laminieren der mindestens zwei ersten Sperrschichten über den organischen lichtemittierenden Stapel, um den organischen lichtemittierenden Schichtenstapel zu kapseln.

17. Verfahren nach Anspruch 15 oder Anspruch 16, weiter umfassend das Vakuumabscheiden von mindestens einem zweiten Sperrstapel zwischen dem Substrat und dem organischen lichtemittierenden Schichtenstapel, um Schutz vor Sauerstoff- und Wasserpermeation vorzusehen, wobei der mindestens eine zweite Sperrstapel eine oder mehrere Sperrschichten und eine oder mehrere Polymerschichten auf einer oder beiden Seiten der Sperrschichten umfasst, wobei das Vakuumabscheiden Folgendes umfasst:
Entspannungsverdampfen und Kondensieren von acrylathaltigen Monomeren, Oligomeren oder Harzen; und Polymerisieren der kondensierten acrylathaltigen Monomere, Oligomere oder Harze, um die Polymerschicht zu bilden; und
Vakuumabscheiden der zweiten Sperrschicht.

18. Verfahren nach Anspruch 15 oder Anspruch 16, wobei in den ersten Sperrstapeln eine oder mehrere Polymerschichten vor der einen oder den mehreren Sperrschichten abgeschieden werden.

19. Verfahren nach Anspruch 17, wobei in dem zweiten Sperrstapel eine oder mehrere Polymerschichten vor der einen oder den mehreren Sperrschichten abgeschieden werden.

20. Verfahren nach Anspruch 16, wobei das Laminieren unter Verwendung eines Klebstoffs ausgeführt wird.

21. Verfahren nach Anspruch 16, wobei das Laminieren unter Verwendung von Hitze ausgeführt wird.

22. Verfahren nach einem der Ansprüche 15 bis 21, wobei die ersten Sperrstapel transparent sind.

23. Verfahren nach Anspruch 17, wobei die eine oder mehreren Sperrschichten der zweiten Sperrstapel im Wesentlichen transparent sind.

24. Verfahren nach Anspruch 23, wobei mindestens eine Sperrschicht des zweiten Sperrstapels opak ist.

## Revendications

1. Dispositif électroluminescent organique encapsulé comprenant :
un substrat ;
un empilement de couches électroluminescentes organiques sur le substrat ; et
au moins deux premiers empilements-barrières pour assurer une protection contre la perméation d'oxygène et d'eau sur l'empilement de couches électroluminescentes organiques et pour encapsuler l'empilement de couches électroluminescentes organiques, chacun des au moins deux premiers empilements-barrières comprenant une ou plusieurs couches barrières et une ou plusieurs couches de polymère sur l'un ou les deux côtés des couches barrières ;
dans lequel les couches barrières sont transparentes et comprennent un matériau choisi parmi les oxydes de métal et les oxydes de silicium, les nitrures de métal et les nitrures de silicium, les carbures de métal et les carbures de silicium, les oxynitrures de métal et les oxynitrures de silicium, et leurs combinaisons ; et
dans lequel une couche de polymère d'un premier empilement-barrière est en contact avec une couche barrière de l'autre premier empilement-barrière ; et
dans lequel le dispositif électroluminescent organique encapsulé peut être obtenu par le procédé de :
dépôt sous vide des empilements-barrières,
le dépôt sous vide comprenant :
l'évaporation éclair et la condensation de monomères, d'oligomères ou de résines contenant un acrylate ; et la polymérisation des monomères, oligomères ou résines contenant un acrylate évaporés et condensés *in situ* sous vide afin de former les couches de polymère ; et
dépôt sous vide des couches barrières.

2. Dispositif électroluminescent organique encapsulé selon la revendication 1, comprenant en outre au moins un second empilement-barrière pour assurer une protection contre la perméation d'oxygène et d'eau situé entre le substrat et l'empilement de couches électroluminescentes organiques, le au moins un second empilement-barrière comprenant une ou plusieurs couches barrières et une ou plusieurs couches de polymère sur l'un ou les deux côtés des couches barrières,
dans lequel le second empilement-barrière peut être obtenu par le procédé de :
dépôt sous vide de l'empilement-barrière, le dépôt sous vide comprenant :
l'évaporation éclair et la condensation de monomères, d'oligomères ou de résines contenant un acrylate ; et la polymérisation des monomères, oligomères ou résines contenant un acrylate évaporés et condensés afin de former la seconde couche de polymère ; et
dépôt sous vide de la seconde couche barrière.

3. Dispositif électroluminescent organique encapsulé selon la revendication 1, dans lequel les premiers empilements-barrières sont transparents.

4. Dispositif électroluminescent organique encapsulé selon la revendication 2, dans lequel les une ou plusieurs couches barrières du second empilement-barrière sont sensiblement transparentes.

5. Dispositif électroluminescent organique encapsulé selon l'une quelconque des revendications précédentes, dans lequel les oxydes de métal et de silicium sont choisis parmi la silice, l'alumine, l'oxyde de titane, l'oxyde d'indium, l'oxyde d'étain, l'oxyde d'indium-étain, et leurs combinaisons.

6. Dispositif électroluminescent organique encapsulé selon l'une quelconque des revendications précédentes, dans lequel le matériau barrière est choisi parmi le nitrure d'aluminium, le nitrure de silicium, et leurs combinaisons.

7. Dispositif électroluminescent organique encapsulé selon l'une quelconque des revendications précédentes, dans lequel le matériau barrière est le carbure de silicium.

8. Dispositif électroluminescent organique encapsulé selon l'une quelconque des revendications précédentes, dans lequel le matériau barrière est l'oxyniture de silicium.

9. Dispositif électroluminescent organique encapsulé selon l'une quelconque des revendications 4 à 8, dans lequel au moins une couche barrière du second empilement-barrière est opaque.

10. Dispositif électroluminescent organique encapsulé selon la revendication 9, dans lequel la au moins une couche barrière opaque est choisie parmi des métaux opaques, des polymères opaques et des céramiques opaques.

11. Dispositif électroluminescent organique encapsulé selon l'une quelconque des revendications précédentes, dans lequel le substrat comprend un matériau de substrat rigide.

12. Dispositif électroluminescent organique encapsulé selon la revendication 11, dans lequel le matériau de substrat rigide est choisi parmi le verre, le métal et le silicium.

13. Dispositif électroluminescent organique encapsulé selon l'une quelconque des revendications 1 à 10, dans lequel le substrat comprend un matériau de substrat flexible.

14. Dispositif électroluminescent organique encapsulé selon la revendication 13, dans lequel le matériau de substrat flexible est choisi parmi des polymères, des métaux, du papier, une étoffe, et leurs combinaisons.

15. Procédé de fabrication d'un dispositif électroluminescent organique encapsulé comprenant :
la fourniture d'un substrat ;
la fourniture d'un empilement de couches électroluminescentes organiques sur le substrat ; et
le dépôt sous vide d'au moins deux premiers empilements-barrières pour assurer une protection contre la perméation d'oxygène et d'eau sur l'empilement de couches électroluminescentes organiques afin d'encapsuler l'empilement de couches électroluminescentes organiques, chacun des au moins deux premiers empilements-barrières comprenant une ou plusieurs couches barrières et une ou plusieurs couches de polymère sur l'un ou les deux côtés des couches barrières ; dans lequel les couches barrières sont transparentes et comprennent un matériau choisi parmi les oxydes de métal et les oxydes de silicium, les nitrures de métal et les nitrures de silicium, les carbures de métal et les carbures de silicium, les oxynitrures de métal et les oxynitrures de silicium, et leurs combinaisons ; et
dans lequel une couche de polymère d'un premier empilement-barrière est en contact avec une couche barrière de l'autre premier empilement-barrière ; et
dans lequel le dépôt sous vide comprend :
l'évaporation éclair et la condensation de monomères, d'oligomères ou de résines contenant un acrylate ; et la polymérisation des monomères, oligomères ou résines contenant un acrylate évaporés et condensés *in situ* sous vide afin de former les couches de polymère ; et
le dépôt sous vide des couches barrières.

16. Procédé de fabrication d'un dispositif électroluminescent organique encapsulé comprenant :
la fourniture d'un substrat ;
la fourniture d'un empilement de couches électroluminescentes organiques sur le substrat ; et
le dépôt sous vide d'au moins deux premiers empilements-barrières pour assurer une protection contre la perméation d'oxygène et d'eau, chacun des au moins deux premiers empilements-barrières comprenant une ou plusieurs couches barrières et une ou plusieurs couches de polymère sur l'un ou les deux côtés des couches barrières ;
dans lequel les couches barrières sont transparentes et comprennent un matériau choisi parmi les oxydes de métal et les oxydes de silicium, les nitrures de métal et les nitrures de silicium, les carbures de métal et les carbures de silicium, les oxynitrures de métal et les oxynitrures de silicium, et leurs combinaisons ; et
dans lequel une couche de polymère d'un premier empilement-barrière est en contact avec une couche barrière de l'autre premier empilement-barrière ;
le dépôt sous vide comprenant :
l'évaporation éclair et la condensation de monomères, d'oligomères ou de résines contenant un acrylate ; et la polymérisation des monomères, oligomères ou résines contenant un acrylate évaporés et condensés *in situ* sous vide afin de former les couches de polymère ; et
le dépôt sous vide des couches barrières ; et
la stratification des au moins deux premiers empilements-barrières sur l'empilement de couches électroluminescentes organiques afin d'encapsuler l'empilement de couches électroluminescentes organiques.

17. Procédé selon la revendication 15 ou la revendication 16, comprenant en outre le dépôt sous vide d'au moins un second empilement-barrière entre le substrat et l'empilement de couches électroluminescentes organiques pour assurer une protection contre la perméation d'oxygène et d'eau, le au moins un second empilement-barrière comprenant une ou plusieurs couches barrières et une ou plusieurs couches de polymère sur l'un ou les deux côtés des couches barrières, le dépôt sous vide comprenant :
l'évaporation éclair et la condensation de monomères, d'oligomères ou de résines contenant un acrylate ; et la polymérisation des monomères, oligomères ou résines contenant un acrylate condensés afin de former la couche de polymère ; et
le dépôt sous vide de la seconde couche barrière.

18. Procédé selon la revendication 15 ou la revendication 16, dans lequel, dans les premiers empilements-barrières, une ou plusieurs couches de polymère sont déposées avant les une ou plusieurs couches barrières.

19. Procédé selon la revendication 17, dans lequel, dans le second empilement-barrière, une ou plusieurs couches de polymère sont déposées avant les une ou plusieurs couches barrières.

20. Procédé selon la revendication 16, dans lequel la stratification est réalisée à l'aide d'un adhésif.

21. Procédé selon la revendication 16, dans lequel la stratification est réalisée à l'aide de chaleur.

22. Procédé selon l'une quelconque des revendications 15 à 21, dans lequel les premiers empilements-barrières sont transparents.

23. Procédé selon la revendication 17, dans lequel les une ou plusieurs couches barrières des seconds empilements-barrières sont sensiblement transparentes.

24. Procédé selon la revendication 23, dans lequel au moins une couche barrière du second empilement-barrière est opaque.
